# EUROPEAN PATENT APPLICATION

(11) **EP 4 156 511 A1**
(43) Date of publication of application: **29.03.2023**
(21) Application number: 21829700.0
(22) Date of filing: 03.06.2021
(51) Int. Cl.: H03F 3/20

(54) **ENVELOPE AMPLIFIER, ENVELOPE TRACKING POWER AMPLIFIER, AND SIGNAL PROCESSING METHOD**

(30) Priority: 24.06.2020 CN 202010595601
(71) Applicant: ZTE Corporation, Shenzhen, Guangdong 518057 (CN)
(72) Inventor: SUN, Hao, Shenzhen, Guangdong 518057 (CN); ZHANG, Xiaoyi, Shenzhen, Guangdong 518057 (CN); YU, Minde, Shenzhen, Guangdong 518057 (CN); QIN, Tianyin, Shenzhen, Guangdong 518057 (CN); DING, Chong, Shenzhen, Guangdong 518057 (CN)
(74) Representative: Osterhoff, Utz
(86) International application number: PCT/CN2021/098170
(87) International publication number: WO 2021/259034

(57) **Abstract**

Disclosed are an envelope amplifier (1), an envelope tracking power amplifier, and a signal processing method. The envelope amplifier (1) includes: a comparator (11), configured to compare a voltage of a received radio frequency envelope signal with a reference voltage of the comparator, and output a first envelope signal whose voltage is less than or equal to the reference voltage and a second envelope signal whose voltage is greater than or equal to the reference voltage; a signal amplifier (12), configured to amplify the first envelope signal; a multi-voltage output circuit, configured to output a corresponding target voltage signal according to the second envelope signal; and a synthesis circuit (14), configured to synthesize the amplified first envelope signal and the target voltage signal, and output the synthesized signal.

## Description

### CROSS-REFERENCE TO RELATED APPLICATIONS

This application claims priority to Chinese Patent Application No. 202010595601.7, filed on June 24, 2020, the entire contents of which are incorporated herein by reference.

### TECHNICAL FIELD

Embodiments of the present application relate to the technical field of communications, and in particular, to an envelope amplifier, an envelope tracking power amplifier, and a signal processing method.

### BACKGROUND

With the rapid development of wireless communication technology, the performance requirements of wireless communication equipment are also getting higher and higher. In a wireless communication system, the radio frequency power amplifier is the main energy-consuming module, and its efficiency can directly affect the efficiency of the entire system.

Envelope tracking techniques are commonly used to achieve high-efficiency power amplifiers. The principle is to adjust the leakage voltage of the power amplifier in real time according to the level of the envelope of the input radio frequency signal, so that the power amplifier can work in the saturation region as much as possible, that is, the power amplifier is made to work in a high-efficiency region as much as possible, thereby improving the efficiency of the power amplifier.

The efficiency of the envelope tracking power amplifier is closely related to the efficiency of the envelope amplifier and the power amplifier, so how to improve the efficiency of the envelope amplifier is also crucial.

### SUMMARY

Embodiments of the present application relate to an envelope amplifier, including: a comparator, configured to compare a voltage of a received radio frequency envelope signal with a reference voltage of the comparator, and output a first envelope signal whose voltage is less than or equal to the reference voltage and a second envelope signal whose voltage is greater than or equal to the reference voltage; a signal amplifier, configured to amplify the first envelope signal; a multi-voltage output circuit, configured to output a corresponding target voltage signal according to the second envelope signal; and a synthesis circuit, configured to synthesize the amplified first envelope signal and the target voltage signal, and output the synthesized signal.

In order to achieve the above objective, embodiments of the present application further provide an envelope tracking power amplifier, including the envelope amplifier as described above and a power amplifier connected to the envelope amplifier.

In order to achieve the above objective, embodiments of the present application further provide a signal processing method, including: comparing a voltage of a received radio frequency envelope signal with a preset reference voltage, outputting a first envelope signal whose voltage is less than or equal to the reference voltage and a second envelope signal whose voltage is greater than or equal to the reference voltage; amplifying the first envelope signal; outputting a corresponding target voltage signal according to the second envelope signal; and combining the amplified first envelope signal with the target voltage signal, and outputting the synthesized signal.

### BRIEF DESCRIPTION OF THE DRAWINGS

FIG. 1 is a schematic diagram of an envelope tracking power amplifier applied to an envelope amplifier according to a first embodiment of the present application.
FIG. 2 is a schematic diagram of an envelope amplifier according to a first embodiment of the present application.
Fig. 3 is a schematic diagram of a radio frequency envelope signal according to a first embodiment of the present application.
FIG. 4 is a schematic diagram of a first envelope signal and a second envelope signal according to a first embodiment of the present application.
FIG. 5 is a schematic diagram of signals output by the envelope amplifier according to a first embodiment of the present application.
FIG. 6 is a schematic diagram of an envelope amplifier according to a second embodiment of the present application.
FIG. 7 is a schematic diagram of an envelope amplifier according to a third embodiment of the present application.
FIG. 8 is a schematic diagram of a multi-voltage output circuit according to a third embodiment of the present application.
FIG. 9 is a specific flowchart of a signal processing method according to a fifth embodiment of the present application.
FIG. 10 is a specific flowchart of a signal processing method according to a sixth embodiment of the present application.

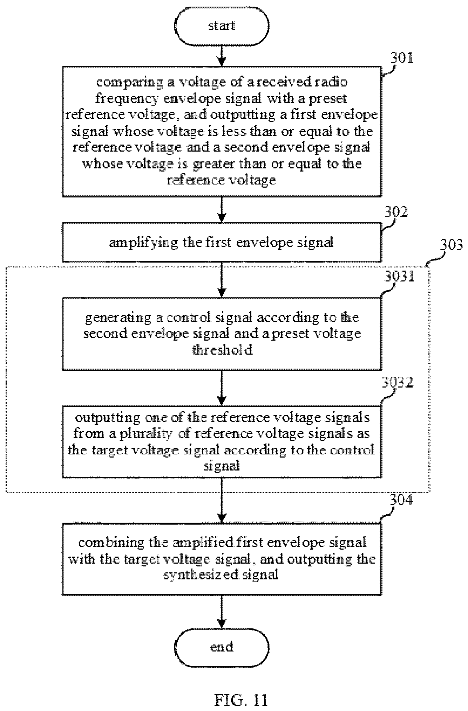

FIG. 11 is a specific flowchart of a signal processing method according to a seventh embodiment of the present application.

### DETAILED DESCRIPTION OF THE EMBODIMENTS

It should be understood that the specific embodiments described here are only used to explain the present application, and are not intended to limit the present application.

In the subsequent description, use of suffixes such as "module", "component" or "unit" for denoting elements is only for facilitating the description of the present application and has no specific meaning by itself. Therefore, "module", "component" or "unit" may be used in combination.

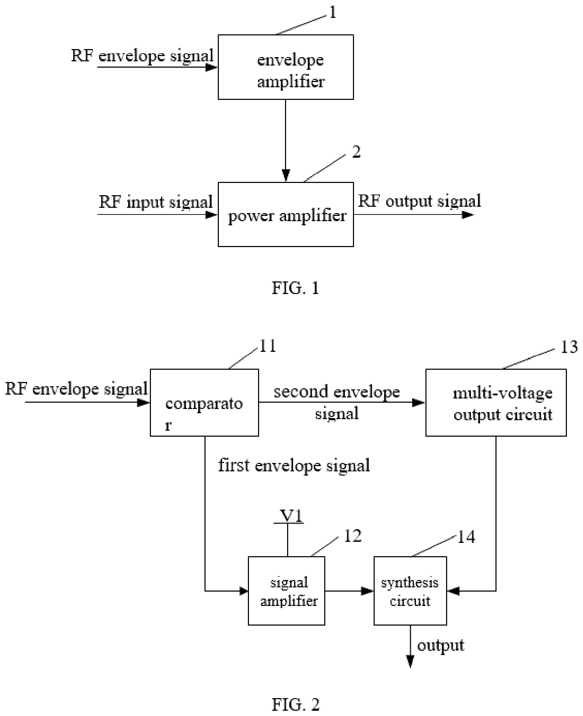

A first embodiment of the present application provides an envelope amplifier, which is applied to an envelope tracking power amplifier, and the envelope tracking power amplifier can be applied to a wireless communication device such as a base station. Please refer to FIG. 1, the envelope tracking power amplifier includes an envelope amplifier 1 and a power amplifier 2 in this embodiment, the radio frequency envelope signal is input into the envelope amplifier 1, the radio frequency input signal is input into the power amplifier 2, and the radio frequency output signal output by the power amplifier 2 is the output of the envelope tracking power amplifier.

In this embodiment, an envelope amplifier includes: a comparator, configured to compare a voltage of a received radio frequency envelope signal with a reference voltage of the comparator, and output a first envelope signal whose voltage is less than or equal to the reference voltage and a second envelope signal whose voltage is greater than or equal to the reference voltage; a signal amplifier, configured to amplify the first envelope signal; a multi-voltage output circuit, configured to output a corresponding target voltage signal according to the second envelope signal; and a synthesis circuit, configured to synthesize the amplified first envelope signal and the target voltage signal, and output the synthesized signal.

Compared with the related art, in the envelope amplifier provided by embodiments of the present application, the comparator compares the voltage of the received radio frequency envelope signal with the reference voltage of the comparator, outputs the first envelope signal whose voltage is less than or equal to the reference voltage to the signal amplifier, and outputs the second envelope signal whose voltage is greater than or equal to the reference voltage to the multi-voltage output circuit. The signal amplifier amplifies the first envelope signal, and inputs the amplified first envelope signal to the synthesis circuit. The multi-voltage output circuit outputs the corresponding target voltage signal to the synthesis circuit according to the second envelope signal. The synthesis circuit synthesizes the received amplified first envelope signal and the target voltage signal, and outputs the synthesized signal. That is, the comparator separates the radio frequency envelope signal, and the signal amplifier outputs the low-voltage portion less than or equal to the reference voltage in the envelope voltage range of the radio frequency envelope signal, thereby compressing the ratio of the output power of the signal amplifier to the total output power of the envelope amplifier to a certain extent, and improving the overall efficiency of the envelope amplifier. The multi-voltage output circuit outputs the high-voltage portion greater than or equal to the reference voltage in the envelope voltage range of the radio frequency envelope signal. Since the low-voltage portion has been output by the signal amplifier, the output range of the multi-voltage output circuit is reduced, and the voltage accuracy is improved when the number of discrete voltages is the same. That is, the efficiency of the envelope amplifier is improved; that is, the efficiency of the envelope amplifier is improved from two aspects of the signal amplifier and the multi-voltage output circuit.

The implementation details of the envelope amplifier in this embodiment will be described in detail below, and the following contents are only the implementation details provided for the convenience of understanding, and are not necessary for the implementation of this solution.

As shown in FIG. 2, an envelope amplifier 1 includes a comparator 11, a signal amplifier 12, a multi-voltage output circuit 13 and a synthesis circuit 14.

The comparator 11 is configured to compare a voltage of a received radio frequency envelope signal with a reference voltage of the comparator, and output a first envelope signal whose voltage is less than or equal to the reference voltage and a second envelope signal whose voltage is greater than or equal to the reference voltage. A reference voltage is preset in the comparator 11, and when a radio frequency envelope signal to be processed is received, the output first envelope signal and the second envelope signal are adjusted according to the voltage of the radio frequency envelope signal. The first envelope signal includes a low-voltage portion less than or equal to the reference voltage in the envelope voltage range of the radio frequency envelope signal. The second envelope signal includes a high voltage portion greater than or equal to the reference voltage in the envelope voltage range of the radio frequency envelope signal. The reference voltage may be set according to the envelope voltage range of the radio frequency envelope signal to be processed, which is not limited in this embodiment.

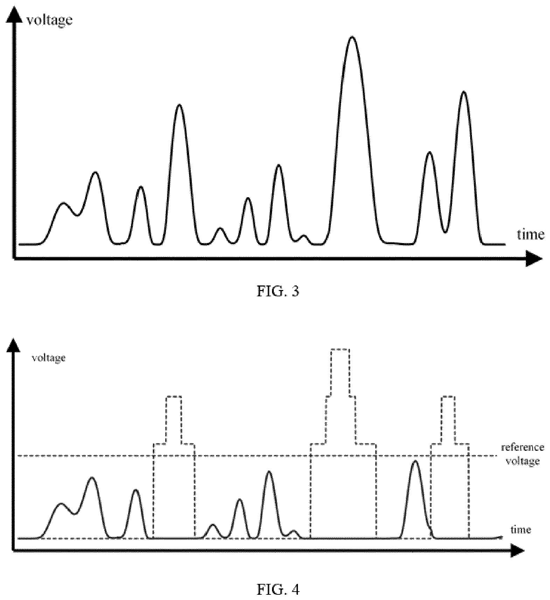

In an embodiment, in response that the voltage of the radio frequency envelope signal is greater than or equal to the reference voltage, the comparator 11 is configured to output the first envelope signal whose voltage is equal to the reference voltage and the second envelope signal whose voltage is equal to the voltage of the radio frequency envelope signal; and/or in response that the voltage of the radio frequency envelope signal is less than the reference voltage, the comparator 11 is configured to output the first envelope signal whose voltage is equal to the voltage of the radio frequency envelope signal, and prohibit outputting the second envelope signal. If the voltage of the radio frequency envelope signal is greater than or equal to the reference voltage, a first envelope signal whose voltage is equal to the reference voltage and a second envelope signal whose voltage is equal to the radio frequency envelope signal are output. If the voltage of the radio frequency envelope signal is less than the reference voltage, the first envelope signal whose voltage is equal to the voltage of the radio frequency envelope signal is output, and the second envelope signal is not output. In FIG. 4, the solid line is the first envelope signal, and the dotted line is the second envelope signal. When the voltage of the radio frequency envelope signal is greater than or equal to the reference voltage, during each signal period of the radio frequency envelope signal, the comparator 11 may output a second envelope signal whose voltage is equal to the peak value of the voltage of the radio frequency envelope signal during the signal period. That is, in each signal period, the voltage of the second envelope signal is equal to the peak voltage of the voltage of the radio frequency envelope signal during the signal period, so that the multi-voltage output circuit can more accurately output the corresponding target voltage signal.

The signal amplifier 12 is configured to amplify the first envelope signal. The signal amplifier 12 is connected to the power supply V1 (such as a DC voltage source), which can amplify the received first envelope signal sent by the comparator 11, and send the amplified first envelope signal to the synthesis circuit 14. The signal amplifier 12 can be a linear amplifier, that is, it can amplify the first envelope signal according to a preset amplification factor.

The multi-voltage output circuit is configured to output a corresponding target voltage signal according to the second envelope signal. The multi-voltage output circuit 13 can output multiple discrete voltage signals. Each second envelope signal corresponds to a different voltage signal. Then, according to the received second envelope signal, a voltage signal corresponding to the second envelope signal can be obtained from a plurality of voltage signals as a target voltage signal, and the target voltage signal can be output to the synthesis circuit 14.

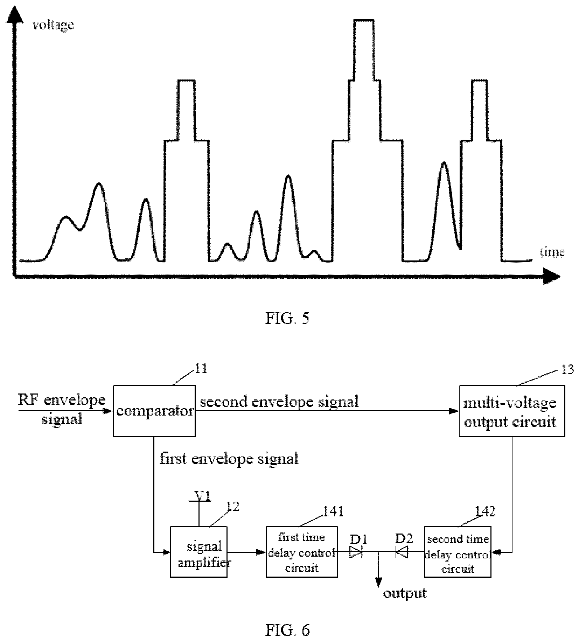

The synthesis circuit 14 is configured to synthesize the amplified first envelope signal and the target voltage signal, and output the synthesized signal. The amplified first envelope signal includes a low-voltage portion of the original radio frequency envelope signal. The target voltage signal includes the high-voltage portion of the original radio frequency envelope signal. The synthesis circuit 14 synthesizes the amplified first envelope signal and the target voltage signal, and then sends the synthesized signal as the output of envelope amplifier 1 to power amplifier 2 in the envelope tracking power amplifier. The synthesized signal can adjust the drain voltage of the power amplifier 2. Please refer to FIG. 5, which shows the signal output from the envelope amplifier 1 after the radio frequency envelope signal in FIG. 3 is input to the envelope amplifier 1.

A second embodiment of the present application provides an envelope amplifier. Compared with the first embodiment, the main improvement of this embodiment is that the synthesis circuit 14 can adjust the time delay of the amplified first envelope signal to be equal to the time delay of the target voltage signal, and then synthesize the two.

In this embodiment, the synthesis circuit 14 is configured to adjust a time delay of the amplified first envelope signal to be equal to a time delay of the target voltage signal, synthesize the first envelope signal with the adjusted time delay and the target voltage signal, and output the synthesized signal.

As shown in FIG. 6, the synthesis circuit 14 includes a first time delay control circuit 141, a second time delay control circuit 142, a first diode D1 and a second diode D2.

As shown in FIG. 6, a first end of the first delay control circuit 141 is connected to the signal amplifier 11, a second end of the first delay control circuit 141 is connected to an anode of the first diode D1, a cathode of the first diode D1 is connected to a cathode of the second diode D2, an anode of the second diode D2 is connected to a first end of the second delay control circuit 142, and a second end of the second delay control circuit 142 is connected to the multi-voltage output circuit 13.

After receiving the amplified first envelope signal sent by the signal amplifier 11, the first time delay control circuit 141 adjusts the time delay of the amplified first envelope signal. After receiving the target voltage signal sent by the multi-voltage output circuit 13, the second time delay control circuit adjusts the time delay of the target voltage signal. Through the time delay adjustment of the two time delay control circuits, the time delay of the amplified first envelope signal is equal to the time delay of the target voltage signal. Then, the amplified first envelope signal is output to the first diode D1, and the target voltage signal is output to the second diode D2, the cathode of the first diode D1 is connected to the cathode of the second diode D2, thus these two signals can be synthesized, and the synthesized signal is output at the junction of the first diode D1 and the second diode D2. The synthesized signal is sent as the output of the envelope amplifier 1 to the power amplifier 2 in the envelope tracking power amplifier. The radio frequency input signal received by the power amplifier 2 is synchronized with the radio frequency envelope signal, therefore the signal input from the envelope amplifier 1 to the power amplifier 2 is also synchronized with the radio frequency input signal received by the power amplifier 2, so that the power amplifier 2 can maintain the working state with optimal efficiency as much as possible.

For example, the time delay of the signal amplifier 11 is T1, that is, the time delay of the amplified first envelope signal output by the signal amplifier relative to the radio frequency envelope signal is T1. The time delay of the multi-voltage output circuit is T2, that is, the time delay of the output target voltage signal relative to the radio frequency envelope signal is T2. Taking T2 being greater than T1 as an example, the first time delay control circuit 141 generates a time delay of T2-T1 for the amplified first envelope signal, at this time, the time delay of the first envelope signal is T2, the second time delay control circuit 142 does not adjust the time delay of the target voltage signal, and the time delay of the target voltage signal is still T2, so that the time delay of the amplified first envelope signal is equal to the time delay of the target voltage signal. Alternatively, the first time delay control circuit 141 generates a time delay of T2-T1+T3 for the amplified first envelope signal, at this time, the time delay of the first envelope signal is T2+T3, the second time delay control circuit 142 generates a time delay of T3 to the target voltage signal, and the time delay of the target voltage signal is T2+T3. Likewise, the time delay of the amplified first envelope signal can be equal to the time delay of the target voltage signal.

Compared with the first embodiment, in this embodiment, the synthesizing circuit can also adjust the time delay of the amplified first envelope signal to be equal to the time delay of the target voltage signal. That is, the time delay generated by the signal amplifier and the multi-voltage output circuit is considered, so that the synthesized signal is synchronized with the original radio frequency envelope signal, and the accuracy of the synthesized signal is improved.

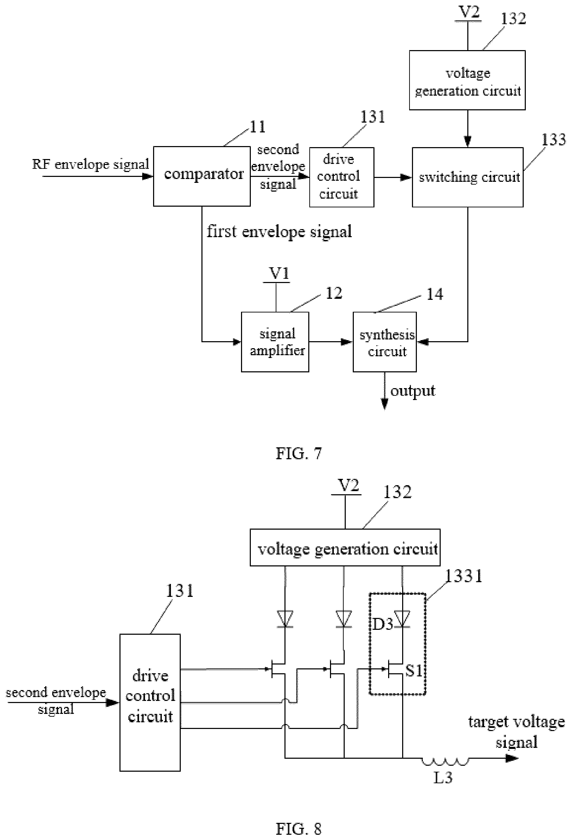

A third embodiment of the present application provides an envelope amplifier. This embodiment is a refinement based on the first embodiment. The main refinements are that as shown in FIG. 7, the multi-voltage output circuit 13 includes a drive control circuit 131, a voltage generation circuit 132, and a switching circuit 133 respectively connected to the drive control circuit 131 and the voltage generation circuit 132.

The drive control circuit 131 is configured to generate a control signal according to the second envelope signal and a preset voltage threshold. At least one voltage threshold is preset in the drive control circuit 131. When the second envelope signal sent by the comparator 11 is received, a control signal is generated according to the magnitude relationship between the voltage of the second envelope signal and each voltage threshold, and the control signal is sent to the switch circuit 133.

The voltage generation circuit 132 is configured to generate a plurality of reference voltage signals, and input the plurality of reference voltage signals to the switching circuit 133. The voltage generation circuit 132 is connected to the power supply V2 (for example, a DC voltage source), which can convert the DC voltage input by the power supply V2 into a plurality of reference voltage signals, and input the converted reference voltage signals to the switching circuit 133. The voltages of the plurality of reference voltage signals are not equal.

The switching circuit 133 is configured to output one of the reference voltage signals as the target voltage signal according to the control signal. The switching circuit 133 can select a reference voltage signal from a plurality of reference voltage signals as a target voltage signal and output the signal to the synthesis circuit 14 according to the received control signal.

For example, as shown in FIG. 8, the switching circuit 133 includes multiple voltage channels 1331 (3 voltage channels are taken as an example in the figure), each voltage channel 1331 is connected to the voltage generation circuit 132 and the drive control circuit 131, and the multiple voltage channels 1331 correspond to the plurality of reference voltage signals one by one. The voltage generation circuit 132 is configured to input each reference voltage signal to the corresponding voltage channel 1331. Each voltage channel 1331 can be turned on or off according to the received control signal. When the voltage channel 1331 is turned on, it outputs the corresponding reference voltage signal to the synthesis circuit 14 as the target voltage signal.

In an embodiment, the switching circuit 133 can also be a power inductor L1, one end of each voltage channel 1331 is connected to the voltage generation circuit 132, and the other end of each voltage channel 1331 is connected to the power inductor L1. The voltage channel 1331 can be turned on or off according to the received control signal. When the voltage channel 1331 is turned on, the corresponding reference voltage signal is output to the synthesis circuit 14 through the power inductor L1 as the target voltage signal, that is, the target voltage signal is output to the synthesis circuit 14 through the power inductor L1. The power inductor L1 can play the role of energy storage and choke, and can protect the envelope amplifier at the same time.

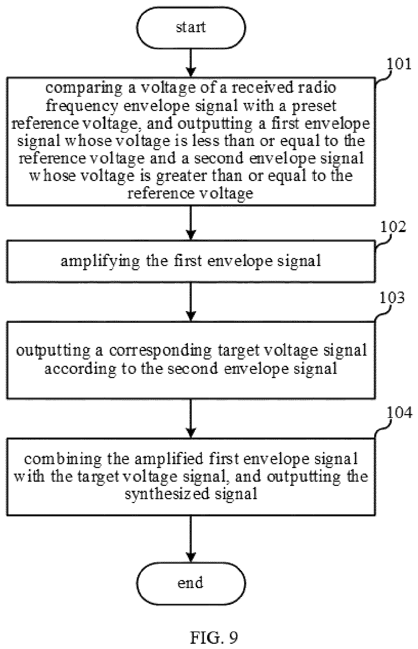

In this embodiment, as shown in FIG. 9, each voltage channel 1331 includes a third diode D3 and a switch S1. An anode of the third diode D3 is connected to the voltage generation circuit 132. A cathode of the third diode D3 is connected to the switch S1. The drive control circuit 131 is connected to a control terminal of the switch S1 of each voltage channel 1331. The switch S1 can be a MOS transistor (Metal-Oxide-Semiconductor Field-Effect Transistor, MOSFET) (take this as an example in the figure). A cathode of the third diode D3 is connected to a drain of the MOS transistor, a source of the MOS transistor is connected to one end of the inductor L1, and a gate of the MOS transistor is connected to the drive control circuit 131.

In this embodiment, the drive control circuit 131 can control the turn-on and turn-off of each switch S1 according to the magnitude relationship between the voltage of the second envelope signal and the preset voltage threshold. Therefore, the reference voltage signal corresponding to the voltage channel 1331 where the switched-on switch S1 is located is output as the target voltage signal.

The drive control circuit 131 controls the number N of voltage thresholds according to the number M of reference voltage signals output by the voltage generation circuit 132, the number of voltage thresholds N is equal to M-1, and the control signal output by the drive control circuit 131 includes P bits, then the number of reference voltage signals M is not greater than 2P.

For example, M is equal to 2, which means that the voltage generation circuit 132 outputs two reference voltage signals (denoted by V1 and V2 respectively), and these two reference voltage signals are respectively input into the corresponding voltage channels 1331. At this time, a voltage threshold X1 is preset in the drive control circuit 131, the control signal output by the drive control circuit 131 includes at least 1 bit (this embodiment takes 1 as an example), one binary bit can represent two states, which are 0 and 1 respectively. Let 0 correspond to the reference voltage signal V1 and 1 correspond to the reference voltage signal V2. When the voltage of the second envelope signal received by the drive control circuit 131 is less than the voltage threshold X1, the control signal 0 is output to the switching circuit 133, The corresponding relationship between different control signals and the voltage channel 1331 is preset in the switching circuit 133. Since 0 corresponds to the reference voltage signal V1, the switching circuit 133 controls the voltage channel 1331 corresponding to the reference voltage signal V1 to be turned on. That is, the switch S1 in the voltage channel 1331 is controlled to be turned on, so that the reference voltage signal V1 can be output to the synthesis circuit 14 as a target voltage signal through the power inductor L1. When the voltage of the received second envelope signal is greater than or equal to the voltage threshold X1, the drive control circuit 131 outputs the control signal 1 to the switching circuit 133, at this time, the switching circuit 133 controls the voltage channel 1332 corresponding to the reference voltage V2 to be turned on, that is, the switch S1 in the voltage channel 1331 is controlled to be turned on, so that the reference voltage signal V2 can be output to the synthesis circuit 14 through the power inductor L1 as the target voltage signal.

M is equal to 3, which means that the voltage generation circuit 132 outputs three reference voltage signals (denoted by V1, V2 and V3 respectively), and the three reference voltage signals are respectively input into the corresponding voltage channels 1331. At this time, the drive control circuit 131 is preset with two voltage thresholds X1, X2 and X1 is less than X2, the control signal output by the drive control circuit 131 includes at least 2 bits (this embodiment takes 2 as an example), and the 2 binary bits can represent four states, which are 00, 01, 10, 11, respectively. Since only three states are required in this embodiment, one state can be selected and not used (taking state 11 as an example), and 00 corresponds to the reference voltage signal V1, 01 corresponds to the reference voltage signal V2, and 10 corresponds to the reference voltage signal V3. The drive control circuit 131 outputs the control signal 00 to the switching circuit 133 when the voltage of the received second envelope signal is less than the voltage threshold X1. When the voltage of the received second envelope signal is greater than or equal to the voltage threshold X1 and less than the voltage threshold X2, the drive control circuit 131 outputs the control signal 01 to the switching circuit 133. The circuit 131 outputs the control signal 10 to the switching circuit 133 when the voltage of the received second envelope signal is greater than or equal to the voltage threshold X2. The specific control method of the switching circuit 133 is similar to the above, and the following will briefly describe with the control signal being 00 as an example. The corresponding relationship between different control signals and the voltage channel 1331 is preset in the switching circuit 133. Since 00 corresponds to the reference voltage signal V1, the switching circuit 133 controls the voltage channel 1331 corresponding to the reference voltage signal V1 to be turned on. That is, the switch S1 in the voltage channel 1331 is controlled to be turned on, so that the reference voltage signal V1 can be output to the synthesis circuit 14 through the power inductor L1 as the target voltage signal. Compared with the first embodiment, this embodiment provides a specific implementation manner of a multi-voltage output circuit.

A fourth embodiment of the present application provides an envelope tracking power amplifier, which is applied to wireless communication devices such as base stations. Please refer to FIG. 1, the envelope tracking power amplifier includes an envelope amplifier 1 and a power amplifier 2 connected to the envelope amplifier 1 according to any one of the first to third embodiments. The envelope amplifier 1 can output the synthesized signal to the power amplifier 2.

Compared with the related art, this embodiment provides an envelope tracking power amplifier using the above envelope amplifier, and the overall efficiency of the envelope tracking power amplifier is improved by improving the efficiency of the envelope amplifier.

A fifth embodiment of the present application provides a signal processing method, which is applied to the envelope amplifier according to any one of the first to third embodiments. Please refer to FIG. 2, this embodiment uses the envelope amplifier in the first embodiment as an example to illustrate the signal processing method.

A specific flowchart of the signal processing method in this embodiment is shown in FIG. 9.

Operation 101, comparing a voltage of a received radio frequency envelope signal with a preset reference voltage, and outputting a first envelope signal whose voltage is less than or equal to the reference voltage and a second envelope signal whose voltage is greater than or equal to the reference voltage.

A reference voltage is preset in the comparator 11, and when a radio frequency envelope signal to be processed is received, the output first envelope signal and the second envelope signal are adjusted according to the voltage of the radio frequency envelope signal. The first envelope signal includes a low-voltage portion less than or equal to the reference voltage in the envelope voltage range of the radio frequency envelope signal. The second envelope signal includes a high voltage portion greater than or equal to the reference voltage in the envelope voltage range of the radio frequency envelope signal. The reference voltage may be set according to the envelope voltage range of the radio frequency envelope signal to be processed, which is not limited in this embodiment.

In an embodiment, the comparing the voltage of the received radio frequency envelope signal with the preset reference voltage, and outputting the first envelope signal whose voltage is less than or equal to the reference voltage and the second envelope signal whose voltage is greater than or equal to the reference voltage includes: in response that the voltage of the radio frequency envelope signal is greater than or equal to the reference voltage, outputting the first envelope signal whose voltage is equal to the reference voltage and the second envelope signal whose voltage is equal to the voltage of the radio frequency envelope signal; and/or in response that the voltage of the radio frequency envelope signal is less than the reference voltage, outputting the first envelope signal whose voltage is equal to the voltage of the radio frequency envelope signal, and prohibit outputting the second envelope signal.

As shown in FIG. 3 and FIG. 4, when receiving the radio frequency envelope signal, the comparator 11 determines the relationship between the voltage of the radio frequency envelope signal and the reference voltage of the comparator. If the voltage of the radio frequency envelope signal is greater than or equal to the reference voltage, a first envelope signal whose voltage is equal to the reference voltage and a second envelope signal whose voltage is equal to the radio frequency envelope signal are output. If the voltage of the radio frequency envelope signal is less than the reference voltage, the first envelope signal whose voltage is equal to the voltage of the radio frequency envelope signal is output, and the second envelope signal is not output. In FIG. 4, the solid line is the first envelope signal, and the dotted line is the second envelope signal. When the voltage of the radio frequency envelope signal is greater than or equal to the reference voltage, during each signal period of the radio frequency envelope signal, the comparator 11 may output a second envelope signal whose voltage is equal to the peak value of the voltage of the radio frequency envelope signal during the signal period. That is, in each signal period, the voltage of the second envelope signal is equal to the peak voltage of the voltage of the radio frequency envelope signal during the signal period, so that the multi-voltage output circuit can more accurately output the corresponding target voltage signal.

Operation 102, amplifying the first envelope signal.

The signal amplifier 12 is connected to the power supply V1 (such as a DC voltage source), which can amplify the received first envelope signal sent by the comparator 11, and send the amplified first envelope signal to the synthesis circuit 14.

Operation 103, outputting a corresponding target voltage signal according to the second envelope signal.

The multi-voltage output circuit 13 can output multiple discrete voltage signals. Each second envelope signal corresponds to a different voltage signal. Then, according to the received second envelope signal, a voltage signal corresponding to the second envelope signal can be obtained from a plurality of voltage signals as a target voltage signal, and the target voltage signal can be output to the synthesis circuit 14.

Operation 104, combining the amplified first envelope signal with the target voltage signal, and outputting the synthesized signal.

The amplified first envelope signal includes a low-voltage portion of the original radio frequency envelope signal. The target voltage signal includes the high-voltage portion of the original radio frequency envelope signal. The synthesis circuit 14 synthesizes the amplified first envelope signal and the target voltage signal, and then sends the synthesized signal as the output of envelope amplifier 1 to power amplifier 2 in the envelope tracking power amplifier. The synthesized signal can adjust the drain voltage of the power amplifier 2. Please refer to FIG. 5, which shows the signal output from the envelope amplifier 1 after the radio frequency envelope signal in FIG. 3 is input to the envelope amplifier 1. Compared with the related art, embodiments of the present application provide a signal processing method, including: comparing a voltage of a received radio frequency envelope signal with a preset reference voltage, and outputting a first envelope signal whose voltage is less than or equal to the reference voltage and a second envelope signal whose voltage is greater than or equal to the reference voltage; amplifying the first envelope signal; outputting a corresponding target voltage signal according to the second envelope signal; and combining the amplified first envelope signal with the target voltage signal, and outputting the synthesized signal. That is, the comparator separates the radio frequency envelope signal, and the signal amplifier outputs the low-voltage portion less than or equal to the reference voltage in the envelope voltage range of the radio frequency envelope signal, thereby compressing the ratio of the output power of the signal amplifier to the total output power of the envelope amplifier to a certain extent, and improving the overall efficiency of the envelope amplifier. The multi-voltage output circuit outputs the high-voltage portion greater than or equal to the reference voltage in the envelope voltage range of the radio frequency envelope signal. Since the low-voltage portion has been output by the signal amplifier, the output range of the multi-voltage output circuit is reduced, and the voltage accuracy is improved when the number of discrete voltages is the same. That is, the efficiency of the envelope amplifier is improved; that is, the efficiency of the envelope amplifier is improved from two aspects of the signal amplifier and the multi-voltage output circuit.

A sixth embodiment of the present application provides a signal processing method. Compared with the fifth embodiment, the main improvement of this embodiment is that: the time delay of the amplified first envelope signal can be adjusted to be equal to the time delay of the target voltage signal, and then the two can be synthesized. Please refer to FIG. 6, and the following description will be made in conjunction with the envelope signal amplifier in the second embodiment.

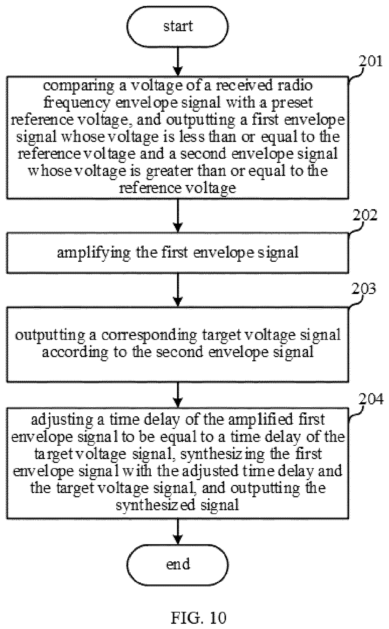

A specific flowchart of the signal processing method in this embodiment is shown in FIG. 10.

Operation 201, comparing a voltage of a received radio frequency envelope signal with a preset reference voltage, and outputting a first envelope signal whose voltage is less than or equal to the reference voltage and a second envelope signal whose voltage is greater than or equal to the reference voltage. Operation 201 is roughly the same as operation 101 in the fifth embodiment, and will not be repeated herein.

Operation 202, amplifying the first envelope signal. Operation 202 is roughly the same as operation 102 in the fifth embodiment, and will not be repeated herein.

Operation 203, outputting a corresponding target voltage signal according to the second envelope signal. Operation 203 is roughly the same as operation 103 in the fifth embodiment, and will not be repeated herein.

Operation 204, adjusting a time delay of the amplified first envelope signal to be equal to a time delay of the target voltage signal, synthesizing the first envelope signal with the adjusted time delay and the target voltage signal, and outputting the synthesized signal.

After receiving the amplified first envelope signal sent by the signal amplifier 11, the first time delay control circuit 141 adjusts the time delay of the amplified first envelope signal. After receiving the target voltage signal sent by the multi-voltage output circuit 13, the second time delay control circuit adjusts the time delay of the target voltage signal. Through the time delay adjustment of the two time delay control circuits, the time delay of the amplified first envelope signal is equal to the time delay of the target voltage signal. Then, the amplified first envelope signal is output to the first diode D1, and the target voltage signal is output to the second diode D2, the cathode of the first diode D1 is connected to the cathode of the second diode D2, thus these two signals can be synthesized, and the synthesized signal is output at the junction of the first diode D1 and the second diode D2. The synthesized signal is sent as the output of the envelope amplifier 1 to the power amplifier 2 in the envelope tracking power amplifier. The radio frequency input signal received by the power amplifier 2 is synchronized with the radio frequency envelope signal, therefore the signal input from the envelope amplifier 1 to the power amplifier 2 is also synchronized with the radio frequency input signal received by the power amplifier 2, so that the power amplifier 2 can maintain the working state with optimal efficiency as much as possible.

Compared with the fifth embodiment, in this embodiment, firstly the time delay of the amplified first envelope signal is adjusted to be equal to the time delay of the target voltage signal. That is, the time delay generated by the signal amplifier and the multi-voltage output circuit is considered, so that the synthesized signal is synchronized with the original radio frequency envelope signal, and the accuracy of the synthesized signal is improved.

A seventh embodiment of the present application provide a signal processing method. Compared with the fifth embodiment, the main improvement of this embodiment is that it provides a specific implementation manner of outputting a corresponding target voltage signal according to the second envelope signal. Please refer to FIG. 7, and the following description will be made in conjunction with the envelope signal amplifier in the third embodiment.

Operation 301, comparing a voltage of a received radio frequency envelope signal with a preset reference voltage, and outputting a first envelope signal whose voltage is less than or equal to the reference voltage and a second envelope signal whose voltage is greater than or equal to the reference voltage. Operation 301 is roughly the same as operation 101 in the fifth embodiment, and will not be repeated herein.

Operation 302, amplifying the first envelope signal. Operation 302 is roughly the same as operation 102 in the fifth embodiment, and will not be repeated herein.

Operation 303 includes the following sub-operations.

Sub-operation 3031, generating a control signal according to the second envelope signal and a preset voltage threshold.

Sub-operation 3032, outputting one of the reference voltage signals from a plurality of reference voltage signals as the target voltage signal according to the control signal.

At least one voltage threshold is preset in the drive control circuit 131. When the second envelope signal sent by the comparator 11 is received, a control signal is generated according to the magnitude relationship between the voltage of the second envelope signal and each voltage threshold, and the control signal is sent to the switch circuit 133.

The voltage generation circuit 132 is connected to the power supply V2 (for example, a DC voltage source), which can convert the DC voltage input by the power supply V2 into a plurality of reference voltage signals, and input the converted reference voltage signals to the switching circuit 133. The voltages of the plurality of reference voltage signals are not equal.

The switching circuit 133 can select a reference voltage signal from a plurality of reference voltage signals as a target voltage signal and output the signal to the synthesis circuit 14 according to the received control signal.

For example, as shown in FIG. 8, the switching circuit 133 includes multiple voltage channels 1331 (3 voltage channels are taken as an example in the figure), each voltage channel 1331 is connected to the voltage generation circuit 132 and the drive control circuit 131, and the multiple voltage channels 1331 correspond to the plurality of reference voltage signals one by one. The voltage generation circuit 132 is configured to input each reference voltage signal to the corresponding voltage channel 1331. Each voltage channel 1331 can be turned on or off according to the received control signal. When the voltage channel 1331 is turned on, it outputs the corresponding reference voltage signal to the synthesis circuit 14 as the target voltage signal.

In an embodiment, the switching circuit 133 can also be a power inductor L1, one end of each voltage channel 1331 is connected to the voltage generation circuit 132, and the other end of each voltage channel 1331 is connected to the power inductor L1. The voltage channel 1331 can be turned on or off according to the received control signal. When the voltage channel 1331 is turned on, the corresponding reference voltage signal is output to the synthesis circuit 14 through the power inductor L1 as the target voltage signal, that is, the target voltage signal is output to the synthesis circuit 14 through the power inductor L1. The power inductor L1 can play the role of energy storage and choke, and can protect the envelope amplifier at the same time.

In this embodiment, as shown in FIG. 9, each voltage channel 1331 includes a third diode D3 and a switch S1. An anode of the third diode D3 is connected to the voltage generation circuit 132. A cathode of the third diode D3 is connected to the switch S1. The drive control circuit 131 is connected to a control terminal of the switch S1 of each voltage channel 1331. The switch S1 can be a MOS transistor (take this as an example in the figure). A cathode of the third diode D3 is connected to a drain of the MOS transistor, a source of the MOS transistor is connected to one end of the inductor L1, and a gate of the MOS transistor is connected to the drive control circuit 131.

In this embodiment, the drive control circuit 131 can control the turn-on and turn-off of each switch S1 according to the magnitude relationship between the voltage of the second envelope signal and the preset voltage threshold/ Therefore, the reference voltage signal corresponding to the voltage channel 1331 where the switched-on switch S1 is located is output as the target voltage signal.

The drive control circuit 131 controls the number N of voltage thresholds according to the number M of reference voltage signals output by the voltage generation circuit 132, the number of voltage thresholds N is equal to M-1, and the control signal output by the drive control circuit 131 includes P bits, then the number of reference voltage signals M is not greater than 2P.

For example, M is equal to 2, which means that the voltage generation circuit 132 outputs two reference voltage signals (denoted by V1 and V2 respectively), and these two reference voltage signals are respectively input into the corresponding voltage channels 1331. At this time, a voltage threshold X1 is preset in the drive control circuit 131, the control signal output by the drive control circuit 131 includes at least 1 bit (this embodiment takes 1 as an example), one binary bit can represent two states, which are 0 and 1 respectively. Let 0 correspond to the reference voltage signal V1 and 1 correspond to the reference voltage signal V2. When the voltage of the second envelope signal received by the drive control circuit 131 is less than the voltage threshold X1, the control signal 0 is output to the switching circuit 133, The corresponding relationship between different control signals and the voltage channel 1331 is preset in the switching circuit 133. Since 0 corresponds to the reference voltage signal V1, the switching circuit 133 controls the voltage channel 1331 corresponding to the reference voltage signal V1 to be turned on. That is, the switch S1 in the voltage channel 1331 is controlled to be turned on, so that the reference voltage signal V1 can be output to the synthesis circuit 14 as a target voltage signal through the power inductor L1. When the voltage of the received second envelope signal is greater than or equal to the voltage threshold X1, the drive control circuit 131 outputs the control signal 1 to the switching circuit 133, at this time, the switching circuit 133 controls the voltage channel 1332 corresponding to the reference voltage V2 to be turned on, that is, the switch S1 in the voltage channel 1331 is controlled to be turned on, so that the reference voltage signal V2 can be output to the synthesis circuit 14 through the power inductor L1 as the target voltage signal.

M is equal to 3, which means that the voltage generation circuit 132 outputs three reference voltage signals (denoted by V1, V2 and V3 respectively), and the three reference voltage signals are respectively input into the corresponding voltage channels 1331. At this time, the drive control circuit 131 is preset with two voltage thresholds X1, X2 and X1 is less than X2, the control signal output by the drive control circuit 131 includes at least 2 bits (this embodiment takes 2 as an example), and the 2 binary bits can represent four states, which are 00, 01, 10, 11, respectively. Since only three states are required in this embodiment, one state can be selected and not used (taking state 11 as an example), and 00 corresponds to the reference voltage signal V1, 01 corresponds to the reference voltage signal V2, and 10 corresponds to the reference voltage signal V3. The drive control circuit 131 outputs the control signal 00 to the switching circuit 133 when the voltage of the received second envelope signal is less than the voltage threshold X1. When the voltage of the received second envelope signal is greater than or equal to the voltage threshold X1 and less than the voltage threshold X2, the drive control circuit 131 outputs the control signal 01 to the switching circuit 133. The circuit 131 outputs the control signal 10 to the switching circuit 133 when the voltage of the received second envelope signal is greater than or equal to the voltage threshold X2. The specific control method of the switching circuit 133 is similar to the above, and the following will briefly describe with the control signal being 00 as an example. The corresponding relationship between different control signals and the voltage channel 1331 is preset in the switching circuit 133. Since 00 corresponds to the reference voltage signal V1, the switching circuit 133 controls the voltage channel 1331 corresponding to the reference voltage signal V1 to be turned on. That is, the switch S1 in the voltage channel 1331 is controlled to be turned on, so that the reference voltage signal V1 can be output to the synthesis circuit 14 through the power inductor L1 as the target voltage signal.

Operation 304, combining the amplified first envelope signal with the target voltage signal, and outputting the synthesized signal. Operation 304 is roughly the same as operation 104 in the fifth embodiment, and will not be repeated herein.

Compared with the fifth embodiment, this embodiment provides a specific implementation manner of outputting a corresponding target voltage signal according to the second envelope signal.

Some embodiments of the present application have been described above with reference to the accompanying drawings, and the scope of the present application is not limited thereby. Any modifications, equivalent replacements and improvements made by those skilled in the art without departing from the scope and essence of the present application shall fall within the scope of the present application.

## Claims

1. An envelope amplifier, **characterized by** comprising:
a comparator, configured to compare a voltage of a received radio frequency envelope signal with a reference voltage of the comparator, and output a first envelope signal whose voltage is less than or equal to the reference voltage and a second envelope signal whose voltage is greater than or equal to the reference voltage;
a signal amplifier, configured to amplify the first envelope signal;
a multi-voltage output circuit, configured to output a corresponding target voltage signal according to the second envelope signal; and
a synthesis circuit, configured to synthesize the amplified first envelope signal and the target voltage signal, and output the synthesized signal.

2. The envelope amplifier according to claim 1, wherein:
in response that the voltage of the radio frequency envelope signal is greater than or equal to the reference voltage, the comparator is configured to output the first envelope signal whose voltage is equal to the reference voltage and the second envelope signal whose voltage is equal to the voltage of the radio frequency envelope signal; and/or
in response that the voltage of the radio frequency envelope signal is less than the reference voltage, the comparator is configured to output the first envelope signal whose voltage is equal to the voltage of the radio frequency envelope signal, and prohibit outputting the second envelope signal.

3. The envelope amplifier according to claim 2, wherein during each signal period of the radio frequency envelope signal, a voltage of the second envelope signal is equal to a peak value of the voltage of the radio frequency envelope signal during the signal period.

4. The envelope amplifier according to claim 1, wherein the synthesis circuit is configured to adjust a time delay of the amplified first envelope signal to be equal to a time delay of the target voltage signal, synthesize the first envelope signal with the adjusted time delay and the target voltage signal, and output the synthesized signal.

5. The envelope amplifier according to claim 4, wherein:
the synthesis circuit comprises a first time delay control circuit, a second time delay control circuit, a first diode and a second diode;
a first end of the first delay control circuit is connected to the signal amplifier, a second end of the first delay control circuit is connected to an anode of the first diode, a cathode of the first diode is connected to a cathode of the second diode, an anode of the second diode is connected to a first end of the second delay control circuit, a second end of the second delay control circuit is connected to the multi-voltage output circuit;
the first time delay control circuit is configured to adjust the time delay of the amplified first envelope signal;
the second time delay control circuit is configured to adjust the time delay of the target voltage signal; and
the adjusted time delay of the first envelope signal is equal to the time delay of the target voltage signal.

6. The envelope amplifier according to claim 1, wherein:
the multi-voltage output circuit comprises a drive control circuit, a voltage generation circuit, and a switching circuit respectively connected to the drive control circuit and the voltage generation circuit;
the drive control circuit is configured to generate a control signal according to the second envelope signal and a preset voltage threshold;
the voltage generation circuit is configured to generate a plurality of reference voltage signals, and input the plurality of reference voltage signals to the switching circuit; and
the switching circuit is configured to output one of the reference voltage signals as the target voltage signal according to the control signal.

7. The envelope amplifier according to claim 6, wherein:
the switching circuit comprises multiple voltage channels, each of the voltage channels is connected to the voltage generation circuit and the drive control circuit, and the multiple voltage channels correspond to the plurality of reference voltage signals one by one;
the voltage generation circuit is configured to input each reference voltage signal to the corresponding voltage channel; and
the voltage channel is configured to output the corresponding reference voltage signal as the target voltage signal in response to being turned on by the control signal.

8. The envelope amplifier according to claim 7, wherein:
the switching circuit further comprises a power inductor connected to each of the voltage channels; and
the voltage channel is configured to output the corresponding reference voltage signal as the target voltage signal through the power inductor in response to being turned on by the control signal.

9. The envelope amplifier according to claim 7, wherein each of the voltage channels comprises a third diode and a switch, an anode of the third diode is connected to the voltage generation circuit, a cathode of the third diode is connected to the switch, and the drive control circuit is connected to a control terminal of the switch of each of the voltage channels.

10. An envelope tracking power amplifier, **characterized by** comprising the envelope amplifier according to any one of claims 1 to 9 and a power amplifier connected to the envelope amplifier.

11. A signal processing method, **characterized by** comprising:
comparing a voltage of a received radio frequency envelope signal with a preset reference voltage, and outputting a first envelope signal whose voltage is less than or equal to the reference voltage and a second envelope signal whose voltage is greater than or equal to the reference voltage;
amplifying the first envelope signal;
outputting a corresponding target voltage signal according to the second envelope signal; and
combining the amplified first envelope signal with the target voltage signal, and outputting the synthesized signal.

12. The signal processing method according to claim 11, wherein the comparing the voltage of the received radio frequency envelope signal with the preset reference voltage, and outputting the first envelope signal whose voltage is less than or equal to the reference voltage and the second envelope signal whose voltage is greater than or equal to the reference voltage comprises:
in response that the voltage of the radio frequency envelope signal is greater than or equal to the reference voltage, outputting the first envelope signal whose voltage is equal to the reference voltage and the second envelope signal whose voltage is equal to the voltage of the radio frequency envelope signal; and/or
in response that the voltage of the radio frequency envelope signal is less than the reference voltage, outputting the first envelope signal whose voltage is equal to the voltage of the radio frequency envelope signal, and prohibit outputting the second envelope signal.

13. The signal processing method according to claim 11, wherein the combining the amplified first envelope signal with the target voltage signal, and outputting the synthesized signal comprises:
adjusting a time delay of the amplified first envelope signal to be equal to a time delay of the target voltage signal, synthesizing the first envelope signal with the adjusted time delay and the target voltage signal, and outputting the synthesized signal.

14. The signal processing method according to claim 11, wherein the outputting the corresponding target voltage signal according to the second envelope signal comprises:
generating a control signal according to the second envelope signal and a preset voltage threshold; and
outputting one of the reference voltage signals from a plurality of reference voltage signals as the target voltage signal according to the control signal.
